Europäisches Patentamt

European Patent Office

Office européen des brevets

(19)

(11) **EP 0 412 701 B1**

(12) EUROPEAN PATENT SPECIFICATION

(45) Date of publication and mention
of the grant of the patent:
**25.09.1996   Bulletin 1996/39**

(51) Int Cl.$^6$: **H01L 29/772**

(21) Application number: **90308353.3**

(22) Date of filing: **30.07.1990**

(54) **Thin film transistor and preparation thereof**

Dünnschicht-Transistor und seine Herstellung

Transistor en couche mince et sa méthode de préparation

(84) Designated Contracting States:
**DE FR GB NL**

(30) Priority:  **31.07.1989  JP  198263/89**
              **25.08.1989  JP  217542/89**
              **25.08.1989  JP  217543/89**

(43) Date of publication of application:
**13.02.1991   Bulletin 1991/07**

(73) Proprietor: **CANON KABUSHIKI KAISHA
Tokyo (JP)**

(72) Inventors:
 • **Koizumi, Toru, c/o Canon Kabushiki Kaisha
   Ohta-ku, tokyo (JP)**
 • **Nakayama, Jun, c/o Canon Kabushiki Kaisha
   Ohta-ku, tokyo (JP)**
 • **Mizutani, Hidemasa,
   c/o Canon Kabushiki Kaisha
   Ohta-ku, tokyo (JP)**

(74) Representative:
**Beresford, Keith Denis Lewis et al
BERESFORD & Co.
2-5 Warwick Court
High Holborn
London WC1R 5DJ (GB)**

(56) References cited:
**EP-A- 0 002 107          EP-A- 0 234 152
DE-A- 2 948 120          DE-A- 3 237 539
US-A- 4 778 258**

 • **PATENT ABSTRACTS OF JAPAN, vol. 7, no. 140
   (E-182)[1285], 18th June 1983; & JP-A-58 52 881
   (OXI DENKI KOGYO K.K.) 29-03-1983**
 • **APPLIED PHYSICS A. SOLIDS AND SURFACES,
   vol. A34, no. 3, July 1984, pages 175-178,
   Heidelberg, DE; A.J. SNELL et al.: "A new
   vertically integrated amorphous silicon
   addressable image sensor"**

## Description

### BACKGROUND OF THE INVENTION

#### Field of the Invention

This invention relates to a semiconductor device to be used for an electronic circuit device, particularly to a thin film transistor having an SOI structure and a method for preparing the same.

#### Related Background Art

Thin film transistors have been recently attracting attention as semiconductor devices which constitute three-dimensional integrated circuits, contact type image sensors and devices for planar displays. Particularly in silicon thin film transistors, higher performance has been effected by making the crystallinity approximate to that of single crystal, and research and development is planned to obtain ultra-thin film (~ 0.1 μm or less) with a very high carrier mobility. However, in such studies, only this specific characteristic is of interest, and how other transistor characteristics may change has not been determined or even considered.

The present inventors have studied overall electrical characteristics of thin film transistors having SOI structures, and consequently have found that the drain dielectric strength when the gate voltage is 0 volt (during OFF) is abruptly deteriorated, if the film thickness of the semiconductor film become thinner than a certain film thickness. The present inventors have made many experiments repeatedly, and consequently have found that the phenomenon as described below occurs. That is, while the avalanche breakdown at the drain edge which determines the drain dielectric strength is generated in the vicinity of the gate interface generally in the case of a thick film, it is instead generated in the vicinity of the interface with the underlying insulating substrate at a certain film thickness or less. More specifically, for example, in SOI (Semiconductor on Insulator) type an insulated gate field effect transistor constituted by formation of a thin film semiconductor layer, a gate insulating film and a gate electrode on a thick insulating substrate, it has been suggested in the prior art that the avalanche breakdown would occur initially in the vicinity of the gate interface because the maximum field is concentrated at the vicinity of the gate interface, and its tendency does not depend on the film thickness of the semiconductor layer. In contrast, the present inventors, on the basis of a new idea to consider the presence of an interface fixed charge (Qss) between the underlying insulating substrate and the semiconductor layer in a real SOI structure, have first performed simulation. Then although, as expected, the electrical field is stronger at the gate interface side as compared with the vicinity of the underlying substrate interface, avalanche breakdown, at a certain film thickness or less, was found in practice to take place in the vicinity of the underlying interface. Although a more detailed theoretical mechanism is now in the course of clarification, probably the avalanche breakdown depends not only on the electrical field, but also on the number of carriers, and when Qss is considered at the gate and also in the vicinity of the underlying interface, it may be estimated to be because of greater influence of the underlying interface on the number of carriers.

For a better understanding of the above, firstly an SOI type field effect transistor of the prior art will be described.

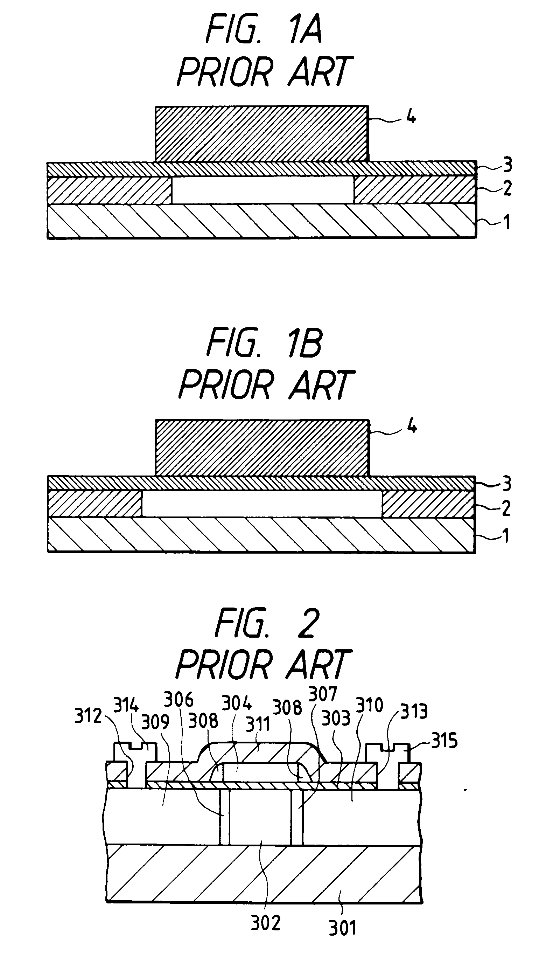

Fig. 1A shows a cross-sectional view of a SOI type thin film field effect transistor of the prior art (A type). Also, Fig. 1B is a cross-section view showing an alternative SOI type thin film field effect transistor having an off-set structure (B type). Here, 1 is an insulating substrate, 2 a semiconductor layer, 3 a gate insulating layer, 4 a gate electrode.

In the A type of the prior art, dielectric strength is, for example, as low as 6 volt. On the other hand, when off-set as in the B type, then even if other structure is the same, due to the influence of the electrical field near the gate interface being relaxed, the electrical field at the underlying interface is also indirectly relaxed. As a result, the dielectric strength is more or less improved. However, its value is, for example, as low as 10 volt, and no practical value can be obtained. In a thin film field effect transistor, because it is a thin film, the region with the strongest electrical field is determined depending on the position of junction between the drain and the channel at the gate insulating film side, and this region is in the vicinity of a vertical line extending from the junction position to the underlying insulating substrate. Hence, because the region with the strongest electrical field and the junction interface where avalanche is susceptible to occur overlap each other in the impurity profile, avalanche is very susceptible to occur. Even when the off-set is the same as the offset $L_{UP}$ described below, it is found that the electrical field relaxation at the underlying interface is not so great.

For relaxation of the electrical field in the vicinity of the drain edge, a Lightly-Doped-Drain (LDD) structure, which has a region with low impurity concentration in the vicinity of the drain boundary, has been known in the art.

Fig. 2 is a cross-section view of a thin film prior art MOSFET having a LDD structure as mentioned above. In Fig. 2, 301 is an insulating substrate, 302 a semiconductor layer, 303 a gate insulating film, 304 a polycrystalline silicon film gate electrode, 309 a source, 310 a drain, 306 a low impurity concentration source region. By forming the low impurity concentration region drain 307 in the vicinity of the drain 310, the high field in the vicinity of the drain 310 is to some extent relaxed. In the same Figure, 308 is NSG, 311 PSG and 314, 315 are electrodes.

However, even in such ultra-thin MOSFET, simultaneously with deterioration of drain dielectric strength by the high field in the vicinity of the above-mentioned drain, if the film thickness of the semiconductor layer 302 is thinner than a certain film thickness, the drain dielectric strength when the gate voltage is 0 volt (during OFF) will deteriorate abruptly as compared with the case of a thick film.

On the other hand, in the structure as shown in Fig. 2, in which the junction interface between the low impurity concentration region 307 of the drain and the high impurity concentration region 310 of the drain is located below the gate insulating film 303, the avalanche breakdown at the drain edge which determines the drain dielectric strength occurs generally in the vicinity of the polycrystalline silicon film 304 in the case of a thick film, while it occurs in the vicinity of the interface with the insulating substrate 301 at a certain film thickness or less as described above.

In the prior art SOI type transistor, the attainment of a satisfactory voltage withstand remains a problem.

SUMMARY OF THE INVENTION

The present invention is intended as a solution to the problem of avalanche breakdown discussed above.

In accordance with a first aspect of this invention there is provided a thin film transistor comprising:

a substrate or layer having an insulating surface; a thin film semiconductor layer, disposed on said insulating surface, and in which are defined a source region and a drain region with a region providing a channel formed therebetween, each having a source-channel junction interface and a drain-channel junction interface, respectively, with said region; and a gate electrode insulated from said semiconductor layer by a gate insulating layer on said semiconductor layer; said drain channel junction interface (Z;Z;Z;-) meeting said gate insulating layer (30;130;230;303) at a first edge which is offset outwards away from the near edge of said gate electrode (140;240) in the direction of the channel length ; wherein said drain-channel junction interface extends from a first edge where it meets said gate insulating layer towards said insulating surface of said substrate or layer and outwardly away from said gate electrode to meet said insulating surface of said substrate or layer obliquely at a second edge which is displaced from said first edge by a distance $L_{UP}$ in the lengthwise direction of said gate electrode normal to the thickness of said semiconductor layer which is related to the thickness $T_{SOI}$ of said semiconductor layer by the relationship:

$$L_{UP}/T_{SOI} \geq 0.35.$$

Since the drain-channel junction interface extends outwardly away from the gate electrode to meet the insulating surface of the substrate or layer obliquely at an edge which is displaced outwardly, not only does it tend to relax electrical field near to this junction interface, but it also ensures that the edge at the interface with the insulating surface of the substrate is displaced from the region where electrical field is most concentrated. This therefore reduces the susceptibility of the transistor to an avalanche breakdown that would occur in the OFF state of the transistor. Practical use may therefore be made of ultra-thin (~ 0.1 μm or less) semiconductor film which has inherent characteristics of high carrier mobility and low parasitic capacity.

Insofar as the transistor aforesaid includes a drain-channel junction interface which extends outwardly and meets the insulating surface at an outwardly displaced edge, it is mentioned that German Patent Application DE-A-2948120 describes a similar structure (fig. 7 thereof). Such structure is adopted as a means of reducing parasitic capacitance.

The drain region of the transistor aforesaid may be of a lightly doped drain (LDD) structure with a junction interface of the lower and higher impurity concentration regions extending from an edge where it meets the gate insulation layer to an edge where it meets the insulating surface of the substrate obliquely.

Insofar as the transistor aforesaid includes a drain-channel interface which extends outwardly and the drain region is of lightly doped drain (LDD) structure, it is mentioned that United States Patent specification US 4,394,182 describes a structure of semiconductor layer thickness 0.45-0.60 μm in which the lower concentration region has an interface with the region providing the channel which extends from an edge where it meets the gate insulation layer outwardly away from the gate electrode to an edge where it meets the higher concentration region. The purpose of this structure is to avoid dielectric breakdown which would otherwise occur in the case of the depletion region of source and drain overlapping. It is also adopted to avoid the "short channel effect".

In the transistor defined above the source-channel junction interface also may be inclined to the normal to the surface of the SOI structure. It may be inclined either inwardly or outwardly.

Where the source-channel junction interface is inclined inwardly, an arrangement is preferred in which the drain region of the transistor is of lightly doped structure as described above and the source region is also of lightly doped structure having an interface between lower and higher dopant impurity concentration regions, which interface extends from one edge where it meets the gate insulation layer, inwardly, to another edge where it meets the insulating surface of the substrate or layer obliquely. The provision of source and drain regions not of lightly doped structure, however, is not precluded.

It is preferable that the surface of the drain-channel junction interface is smooth. Conveniently, it may be a single flat plane.

The thin film semiconductor layer may be of silicon, preferably single-crystal silicon.

According to a second aspect of this invention there is provided a method for manufacturing the thin film transistor, which method comprises:

providing an SOI substrate having a gate insulating layer and a gate electrode thereon, which gate electrode is of length L;

producing a mask of resist material of thickness $R_x$ on said gate insulating layer, which mask has a sidewall at a distance X from the source region side of said gate electrode; and

implanting ions for producing the drain region of said transistor at an implantation angle $\theta_2$ to the normal to the surface of said SOI substrate from the source region side of said gate electrode to produce said drain region;

which method is characterised in that:

the length L, thickness $R_x$, distance X and angle $\theta_2$ satisfy the following relationship:

$$X \leq Rx.\tan \theta_2 \leq X + L.$$

Insofar as the method just defined involves oblique ion implantation, reference is made to Patent Abstracts of Japan, Vol. 7, No. 140 and Japanese Kokai JP-A-5852881 in which a lightly doped drain structure as also a lightly doped source structure are both produced simultaneously by consecutive steps of oblique evaporation from alternate sides of a gate electrode in the presence of a thin mask. The drain-channel junction interface, formed between the lower impurity concentration region of the drain and the region providing the channel, slopes inwardly towards the gate electrode.

It is also convenient to perform the method just defined using a symmetrical mask - i.e. one having sidewalls spaced at a common distance X from each side of the gate electrode and performing oblique ion implantation from each side of the gate electrode. Since the mask sidewalls shadow the opposite sides of the semiconductor layer, the source and drain regions are produced one at a time and not simultaneously.

## BRIEF DESCRIPTION OF THE DRAWINGS

In the accompanying drawings:

Figs. 1A and 1B are schematic cross-sections showing, respectively, two types of known field effect transistor;

Fig. 2 is a schematic cross-section of a known transistor having lightly doped drain and source structures;

Fig. 3 is a schematic cross-section of a SOI type thin film field effect transistor;

Figs. 4A to 4D are schematic cross-sections of a SOI type thin film field effect transistor according to a first preferred embodiment at different stages in course of manufacture;

Fig. 5 is a graph showing the drain dielectric strength characteristics during OFF of the SOI type thin film field effect transistors of a prior art example and the first embodiment;

Fig. 6 is a schematic cross-section showing the preparation method of a SOI type thin film field effect transistor according to a second embodiment;

Fig. 7 is a schematic cross-section of the SOI type thin field effect transistor according to the to the second embodiment;

Figs. 8A and 8B are schematic cross-sections for comparing the structures of the SOI type thin film field effect transistor of the second embodiment with one according to the prior art;

Fig. 9 is a graph showing the drain dielectric strength characteristics during OFF of the SOI type thin film field effect transistor of the second embodiment;

Fig. 10 is a graph showing the relationship between the drain dielectric strength and the displacement amount of the position of the channel-drain junction interface;

Figs. 11A to 11D are schematic illustrations of steps showing an example of the preparation method of the SOI type transistor of the present invention; and

Figs. 12A to 12C show electric circuit diagrams of an electronic circuit device having thin film transistors each according to the present invention, and a schematic illustration of an information processing apparatus including this device.

## DETAILED DESCRIPTION OF THE PREFERRED EMBODIMENTS

To assist in further understanding of this invention, preferred embodiments thereof will be described below with reference to the drawings. The description that follows is given by way of example only.

In a thin film field effect transistor, having an SOI structure provided thus with a semiconductor layer region on the insulating surface of a substrate, and also having a high impurity concentration drain region reaching the insulating surface of the substrate, a current will pass through the whole film when the film thickness of the semiconductor layer becomes about 2-fold or less of the maximum depletion layer depth, avalanche breakdown occurring at the drain edge becomes a problem. Particularly, avalanche in the vicinity of the interface with the insulating surface of the substrate is generated during OFF of the gate voltage to bring about lowering in drain dielectric strength.

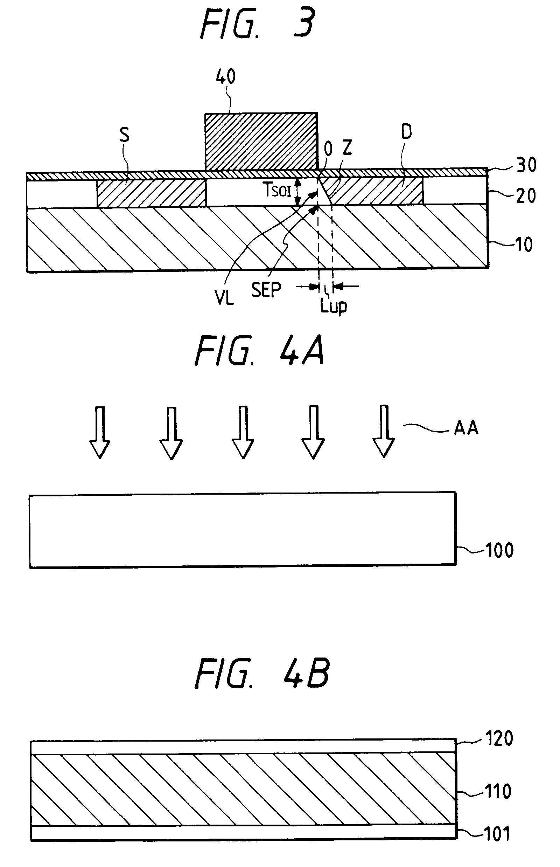

A structure in which the junction interface Z between the drain region D and the region forming the channel (channel-drain junction surface) is further from the gate as it approaches the insulating surface of the substrate, is shown in Fig. 3. The channel-drain junction interface is formed so that $L_{UP}/T_{SOL}$ is 0.35 or more, where:

$L_{UP}$ is a displacement measured in a direction normal to the thickness of the semiconductor layer between the edge 0 of the drain-channel junction interface Z where it meets the gate insulating film 30 and the other edge of this interface Z where it meets the insulating surface of the substrate 10; and

$T_{SOI}$ is the thickness of the semiconductor layer 20.

The drain dielectric strength is markedly improved. The shape of the junction surface may be a constitution which is gradually remote from the gate, and is not particularly limited, but for avoiding unnecessary electrical field concentration, a smooth shape such as single flat plane as shown in Fig. 3, etc. is desirable. Such structure can be produced, for example, by oblique implantation of ions from an angle of 10° or more. The semiconductor film is ultra-thin and has thus a thickness in the range of 100 nm (1000Å).

To the best knowledge of the present inventors, because the semiconductor region is a thin film of thin film SOI structure, the region with the strongest electrical field within the device is not along the junction interface between the drain and the channel, but at a position determined by junction of the drain and the channel on the gate insulating film side, namely in the vicinity along the vertical line from the junction position to a position SEP in Fig. 3 of the insulating surface of the substrate. Hence, by making the above structure, (1) the drain junction interface susceptible to avalanche with the maximum field strength region is displaced; and (2) the field gradient is modified by this displacement, whereby the maximum field strength is lowered. As a result, in case that the same structure for other portions and channel-drain junction are used, the drain dielectric strength during OFF of the MOS type field effect transistor which was about 6 to 8 volt in the prior art can be improved to about 20 volt which had been inconceivable until now.

As for the substrate, an insulating substrate of sapphire, alumina, glass, resin, etc. may be employed, or alternatively, an insulating region formed in a semiconductor substrate or an insulating layer of silicon oxide, silicon nitride, etc. provided on a semiconductor substrate or an electroconductive substrate may be employed, and even an insulating layer of silicon oxide, silicon nitride, etc. as a protective layer provided on a substrate having elements with various functions may be applicable.

As for the gate insulating layer, silicon oxide, silicon nitride, silicon oxynitride etc. can be used.

As for the structures of the gate electrode and the source and drain electrodes, an upper gate stagger type, a lower gate stagger type, an upper gate coplanar type, a lower gate coplanar type, etc. may be employed.

As for the semiconductor layer, a single-crystalline layer, or a non-single-crystalline layer such as a polycrystalline layer, or a microcrystalline layer comprising silicon may be employed, but amongst these, a single crystalline layer, or a polycrystalline layer having high carrier mobility, is preferred.

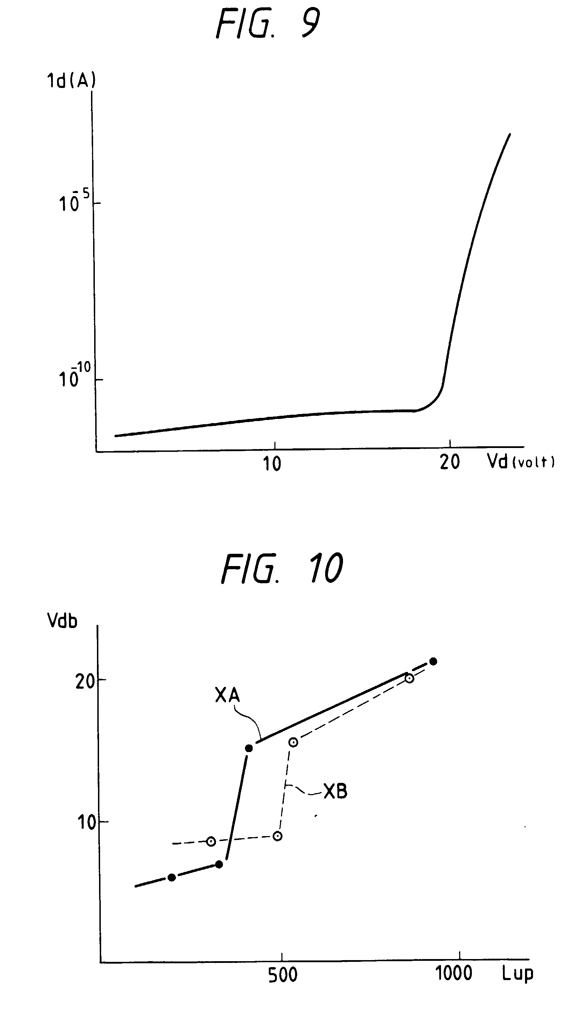

In Fig. 3, 10 is a sapphire substrate as a substrate having insulating surface, 20 a semiconductor layer comprising single crystalline silicon with a layer thickness of 200 nm (2000 Å) formed on the sapphire substrate 10, 30 a silicon oxide film with a layer thickness of 50 nm (500Å) as the gate insulating layer provided on the semiconductor layer 20, and 40 a gate electrode comprising polycrystalline silicon arranged on the silicon oxide film 30.

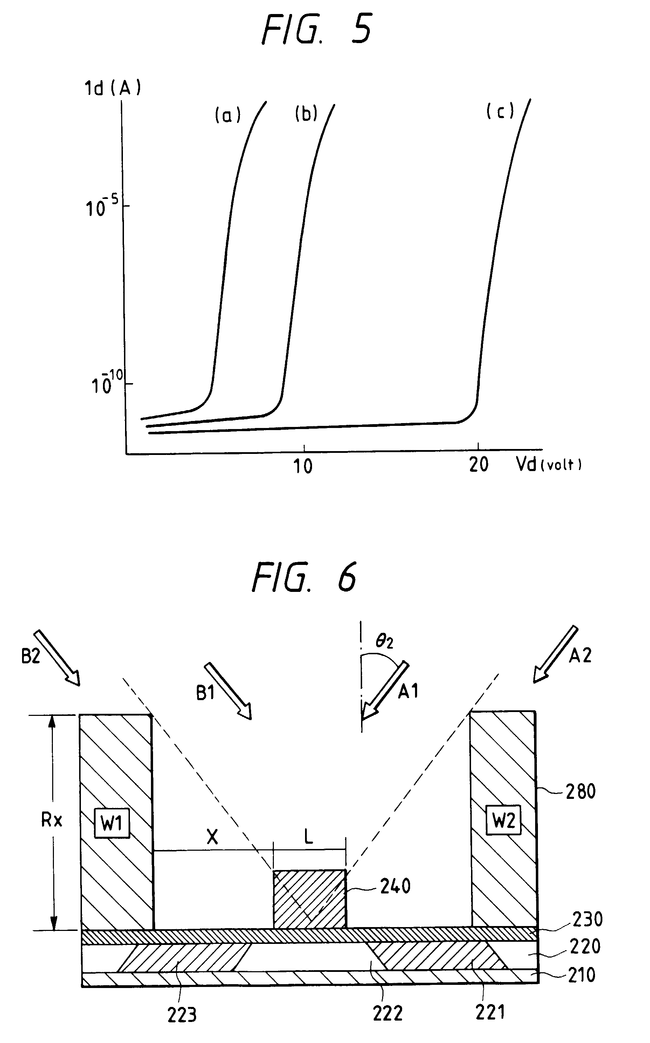

Fig. 5 is a graph showing a result of comparison between transistors respectively according to the prior art and as modified in fig. 3. Curve (a) in this figure is a characteristic of the prior art type, curve (b) is that for a MOS type field effect transistor having an off-set structure, and curve (c) is the OFF state characteristic of the MOS type field effect transistor having the modified structure shown in fig.3. It is shown that this modification in structure compared with off-set structure, has attained a considerable advantageous effect through an action different therefrom.

In Fig. 5, (a) shows the dielectric strength for the structure shown in Fig. 1A, and (b) shows the dielectric strength for the structure shown in Fig. 1B, and (c) shows the dielectric strength for the structure shown in Fig. 3. While (a) is about 6 volt, and (b) is about 10 volt, a dielectric strength of about 21 volt was obtained by this embodiment.

[First embodiment]

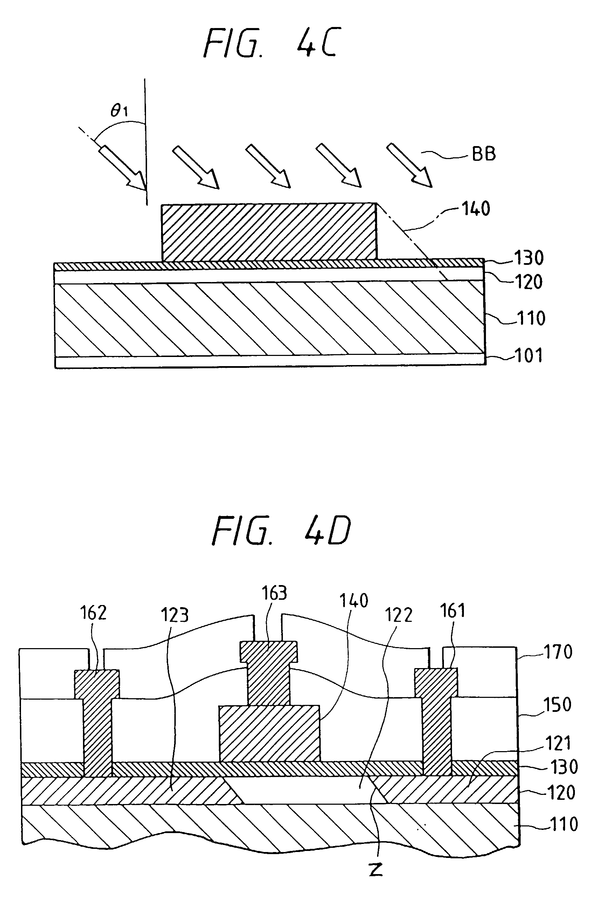

A first embodiment of the present invention will be described, referring now to Fig. 4 and Fig. 5. The structure is shown in Fig. 4D. In this first embodiment, the drain interface Z has an offset structure. The source interface is parallel to the drain interface and is displaced in the direction of the gate electrode the closer it is to the substrate 110. Next, with regard to production process, the embodiment is more clearly explained. For formation of the substrate having insulating surface and the semiconductor layer on said substrate, oxygen was injected onto the P-type single crystalline silicon substrate 100 with a plane direction of (100) at an impurity concentration of $1 \times 10^{16}/cm^2$ as shown by the arrowhead AA at an acceleration voltage of 150 kev, a total dose of $2.14 \times 10^{18}/cm^2$ and a substrate temperature of 600°C. Then, annealing was applied in $N_2$ gas at 1300°C for 3 hours to form a P-type SIMOX substrate with a plane direction of (100) having the semiconductor layer 120 with a film thickness of 100 nm (1000 Å). 101 denotes the lower semiconductor layer and 110 the first insulating layer (see Fig. 4B). On the SOI substrate was formed a gate oxide film 130 with a thickness of 50 nm (500Å) by thermal oxidation, and a polycrystalline film was formed by LP-CVD thereon and $P^{31}$ was ion injected into the polycrystalline silicon, followed by formation of a N-type gate polysilicon electrode with a thickness of 400 nm (4000Å) by patterning. Here, the gate length was made 2 μm and the gate width 10 μm. Next, for formation of a high impurity concentration region as the source-drain region, as shown in Fig. 3, $P^{31}$ (phosphorus) was ion injected at an acceleration voltage of 60 kev from the direction in parallel to the source-drain direction (the direction in which current flows) and with an implantation angle of 43° ($\theta_1$ in Fig. 4C), and subsequently a PSG film 150 was deposited to 600 nm (6000 Å) as an interlayer insulating film, followed by application of a heat treatment at 900°C for 15 minutes for activation of the $P^{31}$ (phosphorus) implanted impurity. In the present embodiment, the implantation angle $\theta_1$ refers to an angle formed with the normal to the surface of the gate insulating film 140 as shown in Fig. 4C. As a result, a sectional structure with the junction interface Z between the low impurity concentration region 122 as the channel region and the high impurity concentration region 121 as the drain region being slanted by 43° relative to the normal to the substrate 110 was obtained. Then, aluminium was vapour deposited and patterned to form a drain electrode wiring 161, a source electrode wiring 162 and a gate electrode wiring 163. By deposition of a PSG film 170 as the protective film, a thin film field effect transistor having the SOI structure shown in Fig. 4D was prepared.

(Example)

By the above described producing process, a plurality of the transistors as shown in Fig. 4D were produced and evaluated. When the dielectric strength during OFF was evaluated a value of 21 volt was obtained.

The present invention, to cope with the problem inherent in the thin film SOI type field effect transistor with the high impurity concentration region reaching the substrate, has improved the drain dielectric strength during OFF through an action different from the prior art by modifying the field distribution of the thin film SOI structure. In the following, description is made as compared with the prior art.

In this embodiment, by making the profile of impurities a structure as shown in Fig. 4D by oblique implantation of ions, (1) the junction interface between the drain and the channel susceptible to avalanche with the region with the strongest field is displaced, (2) and also the potential gradient became gentle corresponding to this displacement to lower the maximum field strength, whereby the drain dielectric strength during OFF has been dramatically improved by about 15 volt from the A type of the prior art and about 11 volt from the B type. Also, as to ON characteristics, electrical field was relaxed in all the regions of the drain edge to improve the kinking phenomenon.

(Second embodiment)

Referring now to Fig. 6 to Fig. 9, a second embodiment of the present invention will be described as also a preferred method of manufacture.

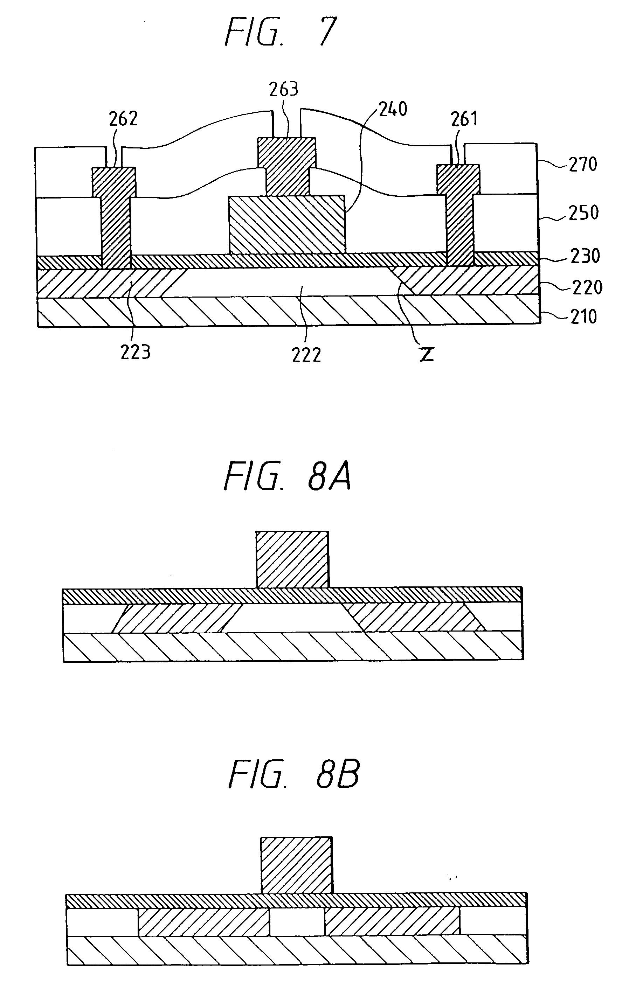

Fig. 7 shows a cross-section of the transistor according to this second embodiment. The source boundary also has an offset structure like the drain boundary, and is displaced further from the gate as it comes nearer to the substrate.

(Example)

Next, regarding the production process, the present embodiment is described in detail.

An SOI substrate with a film thickness 200 nm (2000Å) of silicon single crystal 220 (SOS) on a sapphire substrate 210 and an impurity concentration of 2 x $10^{16}$/$cm^3$ was prepared, and a gate oxide film with a thickness of 80 nm (800Å) was formed by thermal oxidation. After this, polycrystalline silicon was deposited on the oxide film, $P^{31}$ was ion injected and a N-type gate polysilicon electrode 240 with a thickness of 400 nm (4000 Å) was formed by patterning. Here, the gate length was made 2 μm, and the gate width 10 μm.

Next, as shown in Fig. 6, after a resist film 280 with a film thickness (Rx in the drawing) of 2.3 μm was formed as the mask film for impurity diffusion for formation of the source-drain region, $P^{31}$ was ion injected while rotating the substrate at an acceleration voltage of 60 kev from the direction with an implantation angle $\theta_2$ of 32°. The thickness Rx of the resist, the length X of the source-drain region between the gate and the mask and the ion injection angle $\theta_2$ were chosen to satisfy the following relationship:

$$X \leq R_X \cdot \tan \theta_2 \leq X + L \text{ (L is gate length)}.$$

When thus prepared, $R_x$=2.3 μm, X=3 μm and L=2 μm.

Then, as the interlayer insulating film, a PSG film 250 was deposited to a thickness of 600 nm (6000 Å), followed by application of heat treatment at 900°C for 15 minutes for activation of the phosphorus. As a result, a sectional structure with the junction interface Z between the low impurity concentration region of channel 222 and the high impurity concentration region of drain 221 slanted about 30° relative to the substrate could be obtained. Then, by vapour deposition of aluminium, and deposition of PSG as a protective film, a drain electrode wiring 261, a source electrode wiring 22, a gate electrode wiring 263 and a protective layer 270 were formed. Thus, a thin film field effect transistor having the SOI structure shown in Fig. 7 was prepared.

For elucidating the function of the resist walls W1, W2 of the mask film in Fig. 6, Fig. 8A shows a schematic cross-section of the present embodiment, and Fig. 8B, as a reference, when similar ion injection was effected in the case of low W1, W2 as for a conventional source-drain mask (namely Rx · tan θ < X). When W1, W2 are low, the junction interface has no slant, and the drain region spreads below the gate. In this embodiment, since W1, W2 of the drain mask satisfies $X \leq Rx \cdot \tan \theta \leq X + L$, the ions A1, A2 from the A direction in Fig. 6 will not reach the region 221 (for example, drain) (will not be injected thereinto) because W2 forms a shadow in the drain region. And, only the implanting ion A1 reaches the region 223 (for example, source) to be injected thereinto. As a result, a SOI type thin film field effect transistor having a symmetrical off-set structure can be produced.

(Example)

The results of measurement are shown in Fig. 9. Dielectric strength was found to have a practical value of about 20 volt. Also, in ON characteristics, improvement of the kinking phenomenon was effected as compared with the prior art example in which reduction occurred similarly as in the mechanism of drain dielectric strength improvement during OFF in the whole region of the junction interface. Further, due to symmetrical structure, the lay-out is not restricted at all during circuit design, whereby its general purpose applicability could be expanded.

(Example)

Similarly as in the first embodiment, MOS type field effect transistors with $L_{UP}$ of 20 nm (200 Å), 33 nm (330 Å) and 41 nm (410 Å), respectively, were prepared by changing the implantation angles in ion implantation to 11°, 18° and 22°, respectively. As a result, the drain dielectric strengths $V_{db}$ of the respective samples during OFF were found to be 7 V, 8 V and 15 V. Fig. 10 shows the manner of such change in XA. When $L_{UP}$ became 35 nm (350Å) or higher, the drain dielectric strength was markedly improved.

Also, in the case when the semiconductor layer is made to have a thickness of 150 nm (1500Å) or more, as the result of similar measurement of drain dielectric strengths, the dielectric strength was found to be abruptly improved when $L_{UP}$ became 53 nm (530 Å) or more. As described above, by making $L_{UP}/T_{SOI}$ 0.35 or more, the characteristics can be improved.

In the foregoing respective Examples, by making a structure with the junction interface between the drain region and the channel region in the vicinity of the substrate more apart from the gate edge than the drain junction interface in the vicinity of the gate insulating film, particularly the drain junction interface susceptible to avalanche with the region of the strongest field at the substrate interface is displaced, and also the electrical field is relaxed at the junction interface, whereby there is an effect to increase the dielectric strength during OFF by making occurrence of avalanche difficult.

Also, by practising the structure of the present invention by oblique implantation of ions, an off-set structure can be prepared easily, and during ON, there are the effects of reducing hot carriers, and improving the kinking phenomenon.

(Third embodiment)

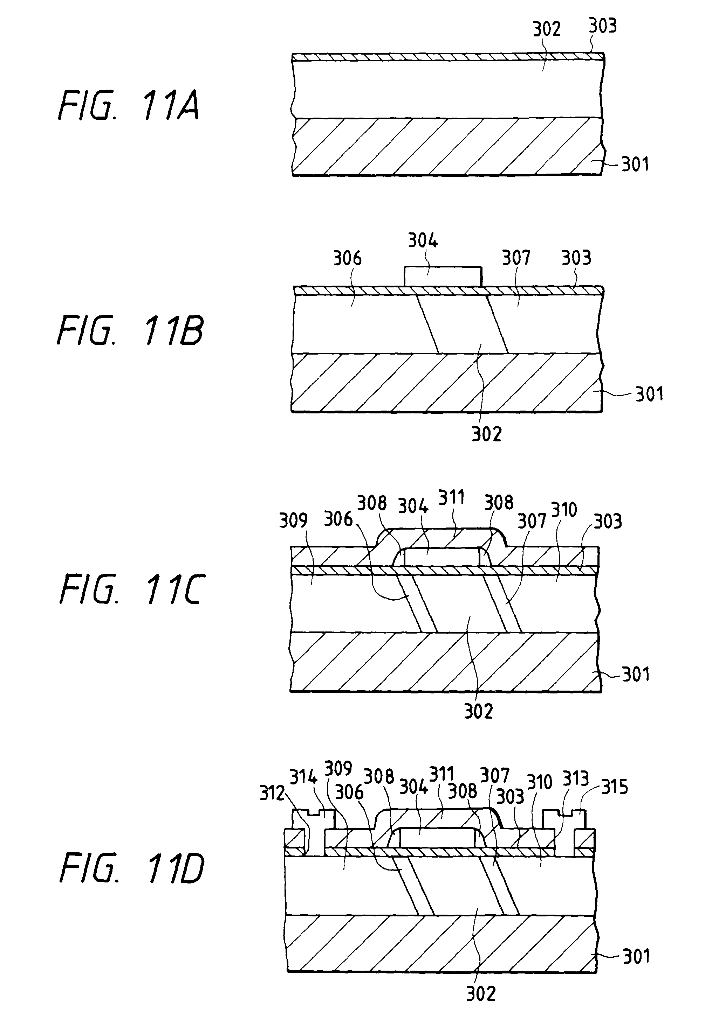

Figs. 11A to 11D are schematic cross-sections showing a preparation method of a third embodiment of the present invention. Structural features with the same constitution as those shown in the prior art example in Fig. 2 are denoted by the same symbols.

This third embodiment is most characterised in that an interface between the channel region and the low impurity concentration drain region, and an interface between the low impurity concentration drain region, and the high impurity drain region are both inclined.

First, as shown in Fig. 11A, a semiconductor layer 302 of 70 nm (700 Å) was formed on a thick insulating substrate 301 and then a gate insulating film 303 of 30 nm (300 Å) was formed.

Next, after deposition of a polycrystalline silicon film to a thickness of 400 nm (4000 Å) as shown in Fig. 11B, phosphorus is diffused to effect etching of the polycrystalline silicon film using photolithography, to form a gate electrode 304.

Further, $5 \times 10^{12}$ of phosphorus (atoms/cm$^2$) as in Fig. 4C is implanted as the impurity obliquely into the semiconductor layer by ion implantation, followed by annealing, to form a low concentration source 306 and a low concentration drain 307.

Next, as shown in Fig. 11C, a NSG film 308 is deposited to 300 nm (3000Å), anisotropic etching effected by RIE to have the NSG film 308 remain only at the side wall of the polycrystalline film gate electrode 304, and then $1 \times 10^{15}$ (atoms/cm$^2$) of phosphorus are implanted obliquely into the semiconductor layer 302 by ion implantation to deposit a PSG film 311, followed by annealing, to form a source 309 and a drain 310.

Next, as shown in Fig. 11D, the PSG film 11 and the oxide film (insulating film) 303 are provided with openings 312 and 313, and electrodes 314 and 315 are formed to form the SOI type transistor of the present embodiment having a trapezoidal cross-section.

The transistors described above may be incorporated in a three dimensional integrated circuit, a contact type image sensor, a liquid crystal display device, and similar devices, to improve significantly the performance thereof. Further, such electronic circuit device can be mounted within information processing apparatus, such as a copier, a facsimile machine, an image reader, a word processor, or a liquid crystal television set.

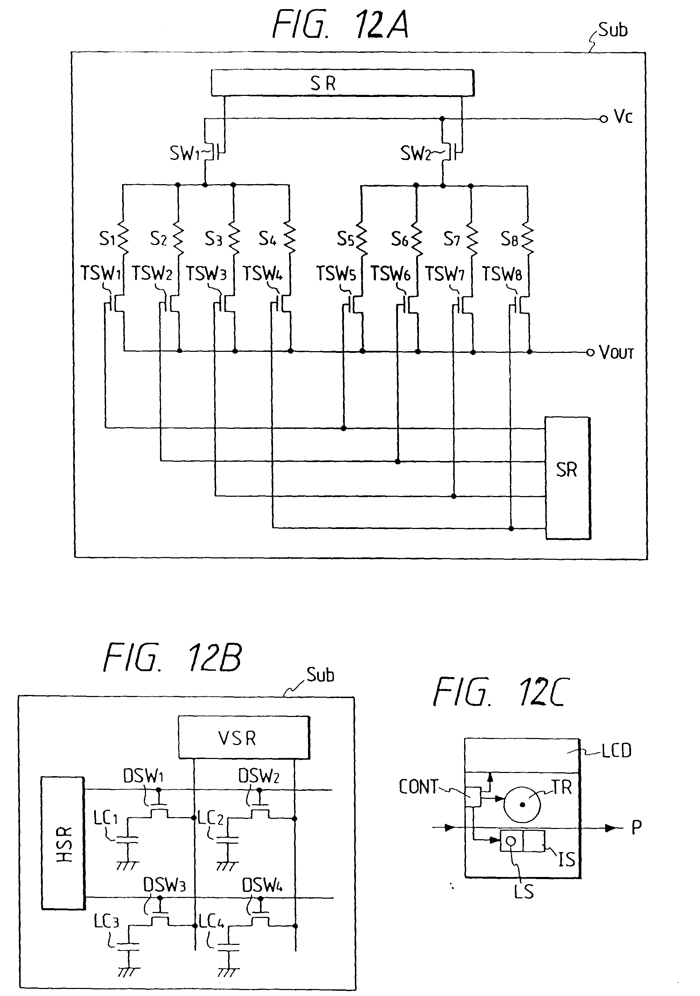

Fig. 12A shows a circuit diagram of a contact type image sensor. The thin film transistor according to the present invention is formed as switch means for signal reading integrally together with a photoelectric conversion element on a common substrate.

In Fig. 12A, a simple example comprising 4 segments x 2 blocks is shown for the purpose of easy understanding. Respective photo-receiving elements $S_1$-$S_8$ are connected four per a block in common through respective block selection TFT switches $SW_1$, $SW_2$ to a reference voltage source VC. Other electrodes of respective photoreceiving elements $S_1$-$S_8$ are connected to segment selection TFT switches $TSW_1$ to $TSW_8$. Respective gates of the TFT switches $TSW_1$-$TSW_8$ are connected commonly interconnected among corresponding segments in each block to constitute gate common lines, and scanned by shift-register SR. Respective sources are commonly interconnected and outputted via common output line $V_{out}$.

Such image sensor IS constitutes an information processing apparatus, together with a light source LS for illuminating an original, conveying roller TR, i.e. a maintaining means, for maintaining an original P at a reading position, and controlling means CONT for controlling the light source LS, the roller TR, and the image sensor IS (Fig. 12C). Fig. 12B shows a circuit diagram of the liquid crystal display device LCD. The thin film transistor of the present invention is used in switches $DSW_1$-$DSW_4$ driving liquid crystal cells $LC_1$-$LC_4$ constituting respective pixels. Gates and sources thereof are connected in a matrix configuration, and driven by a vertical line selection shift register USR and a horizontal line selection shift register HSR. Such liquid display device is connected to the information processing apparatus as shown in Fig. 12C. By means of the control means, an output signal read by the sensor is supplied to the liquid crystal device to display an image. Thus, a monitor of the original reading can be achieved.

## Claims

1. A thin film transistor comprising:

   a substrate or layer (110;210;301) having an insulating surface;
   a thin film semiconductor layer (120;220; -), disposed on said insulating surface, and in which are defined a source region (123;223;306 & 309) and a drain region (121;221;307 & 310) with a region (122;222;302) providing a channel formed therebetween, each having a source-channel junction interface and a drain-channel junction interface (Z;Z; -), respectively, with said region (122;222;302); and
   a gate electrode (140;240;304) insulated from said semiconductor layer (120;220;-) by a gate insulating layer (130;230;303) on said semiconductor layer (120;220;-);
   said drain channel junction interface (Z;Z;Z;-) meeting said gate insulating layer (30;130;230; 303) at a first edge which is offset outwards away from the near edge of said gate electrode (140;240) in the direction of the channel length ; wherein

said drain-channel junction interface (Z;Z;-) extends from said first edge towards said insulating surface of said substrate or layer (110;210; 301) and outwardly away from said gate electrode (140;240;304) to meet said insulating surface of said substrate or layer (110;210;301) obliquely at a second edge which is displaced from said first edge (0;-;-;-) by a distance $L_{UP}$ in the lengthwise direction of said gate electrode (140;240;304) normal to the thickness of said semiconductor layer (120;220;-) which is related to the thickness $T_{SOI}$ of said semiconductor layer (120;220;-) by the relationship;

$$L_{UP}/T_{SOI} \geq 0.35.$$

2. A thin film transistor as claimed in claim 1 wherein said drain region (307,310) comprises a first semiconductor region (307) and a second semiconductor region (310) having a dopant impurity concentration higher than that of said first semiconductor region (307), said first semiconductor region (307) having said drain-channel junction interface with said region (302) providing the channel, and wherein an interface of said first and second semiconductor regions (307,310) also extends from an edge where it meets said gate insulating layer (303) towards said insulating surface of said substrate or layer (301) and outwardly away from said gate electrode (304) to meet said insulating surface of said substrate or layer (301) obliquely at another edge.

3. A thin film transistor as claimed in claim 1 wherein said source-channel junction interface extends from a first edge where it meets said gate insulating layer (303) towards said insulating surface of said substrate or layer (301) and inwardly towards said gate electrode (304) to meet said insulating surface of said substrate or layer (301) obliquely at a second edge.

4. A thin film transistor as claimed in claims 2 and 3 wherein said source region (306,309) comprises a first semiconductor region (306) and a second semiconductor region (309) having a dopant impurity concentration higher than that of said first semiconductor region (306), said first semiconductor region (306) having said source-channel junction interface with said region (302) providing the channel, and wherein an interface of said first and second semiconductor regions (306,309) also extends from an edge where it meets said gate insulating layer (303) towards said insulating surface of said substrate or layer (301) and inwardly towards said gate electrode (304) to meet said insulating surface of said substrate or layer (301) obliquely at another edge.

5. A thin film transistor as claimed in either of claims 3 or 4 wherein said region (302) providing the channel is of rhomboid cross-section.

6. A thin film transistor as claimed in claim 1 wherein said source-channel junction interface extends from a first edge where it meets said gate insulating layer (230) towards said insulating surface of said substrate or layer (210) and outwardly away from said gate electrode (240) to meet said insulating surface of said substrate or layer (210) obliquely at a second edge.

7. A thin film transistor as claimed in claim 6 wherein said region (222) providing the channel is of trapezoid cross-section.

8. A thin film transistor as claimed in claim 7 where said trapezoid cross-section has equal legs.

9. A thin film transistor as claimed in claim 1 wherein said thin film semiconductor layer (120;220;-) is of silicon.

10. A thin film transistor as claimed in claim 9 wherein said thin film semiconductor layer (120;220;-) is of single crystal silicon.

11. A thin film transistor as claimed in claim 1 wherein said drain-channel junction interface (Z) is a single flat plane.

12. A thin film transistor as claimed in any preceding claim wherein said thin film semiconductor layer (120;220;-) is ultra-thin having thus a thickness of $0.1\ \mu\text{m}$ or less.

13. A method for manufacturing the thin film transistor of claim 1, which method comprises:

providing an SOI substrate (210;220) having a gate insulating layer (230) and a gate electrode (240) thereon, which gate electrode (240) is of length L;
producing a mask (280) of resist material of thickness $R_x$ on said gate insulating layer (230), which mask (280) has a sidewall at a distance X from the source region side of said gate electrode (240); and
implanting ions for producing the drain region (221) of said transistor at an implantation angle $\theta_2$ to the normal to the surface of said SOI substrate (210,220) from the source region side of said gate electrode (240) to produce said drain region (221);
which method is characterised in that:
the length L, thickness $R_x$, distance X and angle $\theta_2$ satisfy the following relationship:

$$X \leq R_x.\tan \theta_2 \leq X + L.$$

14. A method as claimed in claim 13 wherein:

said mask (280) has also a sidewall at the distance X from the drain region side of said gate electrode (240); and
ions for producing the source region (223) of said transistor are implanted at the implantations angle $\theta_2$ to be normal to the surface of said SOI substrate (210,220) from the drain region side of said gate electrode (240) to produce said source region (223).

15. An electronic circuit device comprising a thin film transistor ($TSW_1$-$TSW_8$) of claim 1, and a photoelectric conversion element ($S_1$-$S_8$) integrally formed together on a common substrate (Sub).

16. An electronic circuit device comprising a thin film transistor ($DSW_1$ - $DSW_4$) of claim 1 and a liquid crystal cell ($LC_1$-$LC_4$) driven by said thin film transistor ($DSW_1$-$DSW_4$).

17. An information processing apparatus comprising:

an electronic circuit device wherein a thin film transistor ($TSW_1$ - $TSW_8$) of claim 1 and a photoelectric conversion element ($S_1$-$S_8$) are provided integrally on a common substrate (Sub);
means (TR) for maintaining an original (P) at a reading position; and
light source (LS) for illuminating the original.

18. An information processing apparatus comprising:

an electronic circuit device (LCD) having a thin film transistor ($DSW_1$-$DSW_4$) of claim 1 and a liquid crystal cell ($LC_1$-$LC_4$) driven by said thin film transistor ($DSW_1$-$DSW_4$); and
means (CONT) for outputting signal to be inputted into said electronic circuit device (LCD).

**Patentansprüche**

1. Dünnfilm-Transistor mit

einem Substrat oder einer Schicht (110; 210; 301) mit einer isolierenden Oberfläche;
einer auf der isolierenden Oberfläche angeordneten Dünnfilm-Halbleiterschicht (120; 220; -),
in der ein Source-Gebiet (123; 223; 306 & 309) und ein Drain-Gebiet (121; 221; 307 & 310) mit einem einen dazwischen ausgebildeten Kanal ausmachenden Gebiet (122; 222: 302) bestimmt sind, wobei dabei jeweils ein Source-Kanal-Sperrschichtübergang und ein Drain-Kanal-Sperrschichtübergang (Z; Z; -) mit dem Gebiet (122; 222; 302) ausgebildet ist; und einer von der Halbleiterschicht (120; 220; -) durch eine Gate-Isolationsschicht (130; 230; 303) auf der Halbleiterschicht (120; 220; -) isolierten Gate-Elektrode (140; 240; 304);

wobei der Drain-Kanal-Sperrschichtübergang (Z; Z; Z; -) an einer ersten Kante auf die Gate-Isolationsschicht (30; 130; 230; 303) trifft, die von der nahen Kante der Gate-Elektrode (140; 240) in Richtung der Kanallänge nach außen hin versetzt ist; wobei

sich der Drain-Kanal-Sperrschichtübergang (Z; Z, -) von dieser ersten Kante in Richtung zu der isolierenden Oberfläche des Substrats oder der Schicht (110; 210; 301) hin und sich von der Gate-Elektrode (140, 240; 304) nach außen entfernend ersteckt, um an einer zweiten Kante, die von der ersten Kante (0; -; -; -) um einen Abstand $L_{UP}$ in der zur Dicke der Halbleiterschicht (120; 220; -) senkrechten Längsrichtung der Gate-Elektrode (140, 240; 304) versetzt ist, schräg auf die isolierende Oberfläche des Substrates oder der Schicht (110; 210; 301) aufzutreffen, wobei dieser gemäß der folgenden Beziehung auf die Dicke $T_{SOI}$ der Halbleiterschicht (120; 220; -) bezogen ist:

$$L_{UP} / T_{SOI} \geq 0.35.$$

2. Dünnfilm-Transistor nach Anspruch 1, wobei das Drain-Gebiet (307; 310) ein erstes Halbleitergebiet (307) und ein zweites Halbleitergebiet (310) mit einer höheren Dotierstoffkonzentration als der des ersten Halbleitergebiets (307) umfaßt, wobei das erste Halbleitergebiet (307) den Drain-Kanal-Sperrschichtübergang mit dem den Kanal ausmachenden Gebiet (302) aufweist, und wobei sich eine Grenzschicht des ersten und zweiten Halbleitergebiets (307, 310) ebenfalls von einer Kante aus, an der sie auf die Gate-Isolationsschicht (303) trifft, in Richtung zu der isolierenden Oberfläche des Substrats oder der Schicht (301) hin und sich von der Gate-Elektrode (304) nach außen entfernend ersteckt, um an einer anderen Kante schräg auf die isolierende Oberfläche des Substrates oder der Schicht (301) zu treffen.

3. Dünnfilm-Transistor nach Anspruch 1, wobei sich der Source-Kanal-Sperrschichtübergang von einer ersten Kante, an der er auf die Gate-Isolationsschicht (303) trifft, in Richtung zu der isolierenden Oberfläche des Substrats oder der Schicht (301) hin und sich der Gate-Elektrode (304) nach innen hin nähernd ersteckt, um an einer zweiten Kante schräg auf die isolierende Oberfläche des Substrates oder der Schicht (301) aufzutreffen.

4. Dünnfilm-Transistor nach Anspruch 2 und 3, wobei das Source-Gebiet (306; 309) ein erstes Halbleitergebiet (306) und ein zweites Halbleitergebiet (309) mit einer höheren Dotierstoffkonzentration als der des ersten Halbleitergebiets (306) umfaßt, wobei das erste Halbleitergebiet (306) den Source-Kanal-Sperrschichtübergang mit dem den Kanal ausmachenden Gebiet (302) aufweist, und wobei sich eine Grenzschicht des ersten und zweiten Halbleitergebiets (306, 309) ebenfalls von einer Kante aus, an der sie auf die Gate-Isolationsschicht (303) trifft, in Richtung zu der isolierenden Oberfläche des Substrats oder der Schicht (301) hin und sich der Gate-Elektrode (304) nach innen hin nähernd ersteckt, um an einer anderen Kante schräg auf die isolierende Oberfläche des Substrates oder der Schicht (301) zu treffen.

5. Dünnfilm-Transistor nach einem der Ansprüche 3 oder 4, wobei das den Kanal ausmachende Gebiet (302) einen rhomboedrischen Querschnitt hat.

6. Dünnfilm-Transistor nach Anspruch 1, wobei sich der Source-Kanal-Sperrschichtübergang von einer ersten Kante, an der er auf die Gate-Isolationsschicht (230) trifft, in Richtung zu der isolierenden Oberfläche des Substrats oder der Schicht (210) hin und sich von der Gate-Elektrode (240) nach außen entfernend ersteckt, um an einer zweiten Kante schräg auf die isolierende Oberfläche des Substrates oder der Schicht (210) aufzutreffen.

7. Dünnfilm-Transistor nach Anspruch 6, wobei das den Kanal ausmachende Gebiet (222) einen trapezoidförmigen Querschnitt hat.

8. Dünnfilm-Transistor nach Anspruch 7, wobei der trapezoidförmige Querschnitt gleiche Schenkel hat.

9. Dünnfilm-Transistor nach Anspruch 1, wobei die Dünnfilm-Halbleiterschicht (120; 220; -) aus Silizium besteht.

10. Dünnfilm-Transistor nach Anspruch 9, wobei die Dünnfilm-Halbleiterschicht (120; 220; -) aus einkristallinem Silizium besteht.

11. Dünnfilm-Transistor nach Anspruch 1, wobei der Drain-Kanal-Sperrschichtübergang (Z) eine einzelne ebene Fläche ist.

12. Dünnfilm-Transistor nach einem der vorhergehenden Ansprüche, wobei die Dünnfilm-Halbleiterschicht (120; 220; -) ultradünn ist und somit eine Dicke von 0,1 μm oder weniger hat.

**13.** Verfahren zur Herstellung des Dünnfilm-Transistors aus Anspruch 1, mit den Schritten:

Bereitstellen eines SOI-Substrates (210; 220) mit einer Gate-Isolationsschicht (230) und einer Gate-Elektrode (240) darauf, wobei die Gate-Elektrode (240) die Länge L hat;

Erzeugen einer Make (280) aus Schutzlackmaterial der Dicke $R_x$ auf der Gate-Isolationsschicht (230), wobei die Maske (280) im Abstand X von der dem Source-Gebiet zugewandten Seite der Gate-Elektrode (240) eine Seitenbegrenzung hat; und

Implantieren von Ionen zur Erzeugung des Drain-Gebiets (221) des Transistors unter einem Implantationswinkel $\theta_2$ zur Oberflächennormalen des SOI-Substrates (210, 220) von der dem Source-Gebiet zugewandten Seite der Gate-Elektrode (240) aus, um das Drain-Gebiet (221) zu erzeugen;

wobei das Verfahren dadurch gekennzeichnet ist, daß

die Länge L, die Dicke $R_x$, der Abstand X sowie der Winkel $\theta_2$ der folgenden Beziehung genügen:

$$X \leq R_x.\tan \theta_2 \leq X + L.$$

**14.** Verfahren nach Anspruch 13, wobei

die Maske (280) ebenfalls im Abstand X von der dem Drain-Gebiet zugewandten Seite der Gate-Elektrode (240) eine Seitenbegrenzung hat; und

Ionen zur Erzeugung des Source-Gebiets (223) des Transistors unter dem Implantationswinkel $\theta_2$ zur Oberflächennormalen des SOI-Substrates (210, 220) von der dem Drain-Gebiet zugewandten Seite der Gate-Elektrode (240) aus implantiert werden, um das Source-Gebiet (221) zu erzeugen.

**15.** Elektronische Schaltkreiseinrichtung mit einem Dünnfilm-Transistor ($TSW_1$ - $TSW_8$) nach Anspruch 1 und einem photoelektrischen Wandlerelement ($S_1$ - $S_8$), die zusammen auf einem gemeinsamen Substrat (Sub) einstückig ausgebildet sind.

**16.** Elektronische Schaltkreiseinrichtung mit einem Dünnfilm-Transistor ($DSW_1$ - $DSW_4$) nach Anspruch 1 und einer von dem Dünnfilm-Transistor ($DSW_1$ - $DSW_4$) angesteuerten Flüssigkristallzelle ($LC_1$ - $LC_4$).

**17.** Informationsverarbeitungvorrichtung mit:

einer elektronischen Schaltkreiseinrichtung, bei der ein Dünnfilm-Transistor ($TSW_1$ - $TSW_8$) nach Anspruch 1 und ein photoelektrisches Wandlerelement ($S_1$ - $S_8$) auf einem gemeinsamen Substrat (Sub) einstückig ausgebildet sind;

einer Einrichtung (TR) zum Halten einer Vorlage (P) in einer Leseposition; und

einer Lichtquelle (LS) zum Beleuchten der Vorlage.

**18.** Informationsverarbeitungvorrichtung mit:

einer elektronischen Schaltkreiseinrichtung (LCD) mit einem Dünnfilm-Transistor ($DSW_1$ - $DSW_4$) nach Anspruch 1 und einer von dem Dünnfilm-Transistor ($DSW_1$ - $DSW_4$) angesteuerten Flüssigkristallzelle ($LC_1$ - $LC_4$); und

einer Einrichtung (CONT) zur Ausgabe eines der elektronischen Schaltkreiseinrichtung (LCD) einzugebenden Signals.

**Revendications**

**1.** Transistor à couche mince comprenant :

un substrat ou une couche (110;210;301) possédant une surface isolante;

une couche semiconductrice formant couche mince (120;220; -), disposée sur ladite surface isolante et dans laquelle sont définies une région de source (123;223;306 & 309) et une région de drain (121;221;307 & 310), entre lesquelles est formée une région (122;222;302) formant un canal et dont chacune forme, avec ladite région (122;222; 302), respectivement, une interface de jonction source-canal et une interface de jonction drain-canal (Z;Z; -) ; et

une électrode de grille (140;240;304) isolée par rapport à ladite couche semiconductrice (120; 220;-) par une couche d'isolation de grille (130; 230;303) sur ladite couche semiconductrice (120;220;-);

ladite interface de jonction drain-canal (Z;Z;-) rencontrant ladite couche d'isolation de grille (30;130; 230;303) au niveau d'un premier bord, qui est décalé vers l'extérieur en s'écartant du bord proche de ladite électrode de grille (140; 240) dans le sens de la longueur du canal dans lequel

ladite interface de jonction drain-canal (Z;Z;-) s'étend depuis ledit premier bord en direction de ladite surface isolante dudit substrat ou de ladite couche (110; 210;301) et vers l'extérieur en s'écartant de ladite électrode de grille (140; 240;304) pour rencontrer ladite surface isolante dudit substrat ou de ladite couche (110;210; 301) obliquement au niveau d'un second bord qui est décalé par rapport audit premier bord (0;-;-;-) d'une distance $L_{UP}$ dans le sens de la longueur de ladite électrode de grille (140;240; 304) perpendiculairement à l'épaisseur de ladite couche semiconductrice (120;220;-) qui est associée à l'épaisseur $T_{SOI}$ de ladite couche semiconductrice (120;220; -) conformément à la relation :

$$L_{UP}/T_{SOI} \geq 0,35.$$

2. Transistor à couche mince selon la revendication 1, dans lequel ladite région de drain (307, 310) comprend une première région semiconductrice (307) et une seconde région semiconductrice (310) possédant une concentration d'impuretés dopantes, supérieure à celle de ladite première région semiconductrice (307), ladite première région semiconductrice (307) possédant ladite interface de jonction drain-canal avec ladite région (302) formant le canal, et dans lequel une interface entre lesdites première et seconde régions semiconductrices (307,310) s'étend également à partir d'un bord, où elle rencontre ladite couche isolante de grille (303), en direction de ladite surface isolante dudit substrat ou de ladite couche (301) et vers l'extérieur en s'écartant de ladite électrode de grille (304) pour rencontrer obliquement ladite surface isolante dudit substrat ou de ladite couche (301) au niveau d'un autre bord.

3. Transistor à couche mince selon la revendication 1, dans lequel ladite interface de jonction source-canal s'étend à partir d'un premier bord, où elle rencontre ladite couche isolante de grille (303), en direction de ladite surface isolante dudit substrat ou de ladite couche (301) et vers l'intérieur en direction de ladite électrode de grille (304) pour rencontrer obliquement ladite surface isolante dudit substrat ou de ladite couche (301), au niveau d'un second bord.

4. Transistor à couche mince selon les revendications 2 et 3, dans lequel ladite région de source (306,309) comprend une première région semiconductrice (306) et une seconde région semiconductrice (309) possédant une concentration d'impuretés dopantes, supérieure à celle de ladite première région semiconductrice (306), ladite première région semiconductrice (306) possédant ladite interface de jonction source-canal avec ladite région (302) formant le canal, et dans lequel une interface entre lesdites première et seconde régions semiconductrices (306,309) s'étend également depuis un bord, où elle rencontre ladite couche d'isolation de grille (303), en direction de ladite surface isolante dudit substrat ou de ladite couche (301) et vers l'intérieur en direction de ladite électrode de grille (304) pour rencontrer obliquement ladite surface isolante dudit substrat ou de ladite couche (301), au niveau d'un autre bord.

5. Transistor à couches minces selon l'une ou l'autre des revendications 3 ou 4, dans lequel ladite région (302) formant le canal possède une section transversale en losange.

6. Transistor à couches minces selon la revendication 1, dans lequel ladite interface de jonction source-canal s'étend depuis un premier bord, au niveau duquel elle rencontre ladite couche d'isolation de grille (230) en direction de ladite surface isolante dudit substrat ou de ladite couche (210) et vers l'extérieur en s'écartant de ladite électrode de grille (240) pour rencontrer obliquement ladite surface isolante dudit substrat ou de ladite couche (210) au niveau d'un second bord.

7. Transistor à couche mince selon la revendication 6, dans lequel ladite région (222) formant le canal possède une section transversale trapézoïdale.

8. Transistor à couche mince selon la revendication 7, dans lequel ladite section transversale trapézoïdale comporte des côtés obliques égaux.

9. Transistor à couche mince selon la revendication 1, dans lequel ladite couche semiconductrice formant couche mince (120;220;-) est en silicium.

10. Transistor à couche mince selon la revendication 9, dans lequel ladite couche semiconductrice formant couche mince (120;220;-) est en silicium monocristallin.

11. Transistor à couche mince selon la revendication 1, dans lequel ladite interface de jonction drain-canal (Z) est formée d'un seul plan.

12. Transistor à couche mince selon l'une quelconque des revendications précédentes, dans lequel ladite couche semiconductrice formant couche mince (120; 220;-) est ultramince et possède une épaisseur de 0,1 $\mu m$ ou moins.

13. Procédé pour fabriquer le transistor à couche mince selon la revendication 1, lequel procédé consiste à :

prévoir un substrat SOI (210;220) sur lequel sont disposées une couche d'isolation de grille (230) et une électrode de grille (240), l'électrode de grille (240) ayant une longueur L; produire un masque (280) formé en résine photosensible possédant une épaisseur $R_x$ sur ladite couche d'isolation de grille (230), ce masque (280) possédant une paroi latérale située à une distance X du côté de ladite électrode de grille (240), situé vers la région de source; et implanter des ions pour produire la région de drain (221) dudit transistor sous un angle d'implantation $\theta_2$ par rapport à la normale à la surface dudit substrat SOI (210, 220) à partir du côté de ladite électrode de grille (240), situé vers la région de source, pour produire ladite région de drain (221);

lequel procédé est caractérisé en ce que :

la longueur L, l'épaisseur $R_x$, la distance X et l'angle $\theta_2$ satisfont à la relation suivante :

$$X \leq R_x . \tan \theta_2 \leq X + L.$$

14. Procédé selon la revendication 13, selon lequel :

ledit masque (280) possède également une paroi latérale située à la distance X du côté de ladite électrode de grille (240), situé vers la région de drain; et

des ions pour produire la région de source (223) dudit transistor sont implantés sous l'angle d'implantation $\theta_2$ par rapport à la normale à la surface dudit substrat SOI (210,220) à partir du côté de ladite électrode de grille (240), tournée vers la région de drain, pour produire ladite région de source (223).

15. Dispositif à circuit électronique comprenant un transistor à couche mince ($TSW_1$-$TSW_8$) selon la revendication 1, et un élément de conversion photoélectrique ($S_1$-$S_8$) formé conjointement d'un seul tenant sur un substrat commun (Sub).

16. Dispositif à circuit électronique comprenant un transistor à couche mince ($DSW_1$-$DSW_4$) selon la revendication 1 et une cellule à cristaux liquides ($LC_1$-$LC_4$) commandée par ledit transistor à couche mince ($DSW_1$-$DSW_4$).

17. Appareil de traitement d'informations comprenant :

un dispositif à circuit électronique, dans lequel le transistor à couche mince ($TSW_1$-$TSW_8$) selon la revendication 1 et un élément de conversion photoélectrique ($S_1$-$S_8$) sont prévus d'un seul tenant sur un substrat commun (Sub) ;

des moyens (TR) pour maintenir un original (P) dans une position de lecture; et

une source de lumière (LS) pour éclairer l'original.

18. Appareil de traitement d'informations comprenant :

un dispositif à circuit électronique (LCD) possédant un transistor à couche mince ($DSW_1$-$DSW_4$) selon la revendication 1 et une cellule à cristaux liquides ($LC_1$-$LC_4$) commandée par

ledit transistor à couche mince ($DSW_1$-$DSW_4$) ; et

des moyens (CONT) pour délivrer le signal devant être introduit dans ledit dispositif à circuit électronique (LCD).

# FIG. 1A
## PRIOR ART

# FIG. 1B
## PRIOR ART

# FIG. 2
## PRIOR ART

*FIG. 3*

*FIG. 4A*

*FIG. 4B*

## FIG. 4C

## FIG. 4D

## FIG. 5

## FIG. 6

## FIG. 7

## FIG. 8A

## FIG. 8B

# FIG. 9

# FIG. 10

FIG. 11A

FIG. 11B

FIG. 11C

FIG. 11D

# FIG. 12A

# FIG. 12B

# FIG. 12C